# EUROPEAN PATENT APPLICATION

(11) **EP 4 287 802 A1**
(43) Date of publication of application: **06.12.2023**
(21) Application number: 23176259.2
(22) Date of filing: 31.05.2023
(51) Int. Cl.: H05K 7/20, H02S 40/32, H01L 23/433

(54) **PACKAGE STRUCTURE AND PHOTOVOLTAIC OPTIMIZER**

(30) Priority: 31.05.2022 CN 202210607575
(71) Applicant: Huawei Digital Power Technologies Co., Ltd., Shenzhen, 518043 (CN)
(72) Inventor: ZHANG, Xiaojie, Shenzhen, 518043 (CN)
(74) Representative: Thun, Clemens

(57) **Abstract**

A package structure and a photovoltaic optimizer are provided. The package structure includes a first housing, a circuit board, and a heat insulation part. The circuit board is disposed inside the first housing, a first heating device and a second heating device may be disposed on a first surface of the circuit board at an interval, and heat generated by the first heating device at maximum power is greater than heat generated by the second heating device at maximum power. A first end of the heat insulation part may be located on a side wall, of the first housing, opposite to the first surface of the circuit board, a second end of the heat insulation part may extend toward the first surface of the circuit board, and the heat insulation part separates the first heating device and the second heating device on two sides of the heat insulation part. The heat insulation part separates the first heating device from the second heating device, to slow down heat transfer from the first heating device to the second heating device, thereby alleviating a phenomenon of baking the second heating device by the first heating device, preventing the second heating device from overheating due to baking by the first heating device, and ensuring operating reliability of the package structure.

## Description

### TECHNICAL FIELD

This application relates to the field of electronic product technologies, and in particular, to a package structure and a photovoltaic optimizer.

### BACKGROUND

Package structures, such as a photovoltaic optimizer, a power module, and other potting or plastic packaging products, are designed to be miniaturized and highly dense. A small size and high power of the package structure pose a great challenge to a heat dissipation technology. In order to effectively improve an overall heat dissipation capability of the package structure, a main technical means currently used is to fill a heat conductive material, such as a potting material, as a whole inside a housing of the package structure.

However, different types of devices are usually disposed on a circuit board inside the housing of the package structure, including a heating device with a high heat amount and a high temperature specification, for example, a metal-oxide-semiconductor field-effect transistor (metal-oxide-semiconductor field-effect transistor, MOSFET) (whose temperature specification is usually 150°C) or a magnetic device (whose temperature specification is usually 130°C), and also including a low-temperature device with a low heat amount and a low temperature specification, for example, a control chip (whose temperature specification is usually 105°C). Because the heat conductive material is filled as a whole inside the housing of the package structure, heat of the heating device is transferred to a nearby low-temperature device by using the heat conductive material. As a result, the low-temperature device is baked, causing overheating to the low-temperature device, and affecting overall reliability of the package structure.

### SUMMARY

This application provides a package structure and a photovoltaic optimizer, to resolve a problem that a heating device bakes a low-temperature device.

According to a first aspect, this application provides a package structure. The package structure may include a first housing, a circuit board, and a heat insulation part. The circuit board is disposed inside the first housing, a first heating device and a second heating device may be disposed on a first surface of the circuit board at an interval, and heat generated by the first heating device at maximum power may be greater than heat generated by the second heating device at maximum power. A first end of the heat insulation part may be located on a side wall, of the first housing, opposite to the first surface of the circuit board, a second end of the heat insulation part may extend toward the first surface of the circuit board, and the heat insulation part separates the first heating device and the second heating device on two sides of the heat insulation part.

In the technical solution provided in this application, the heat insulation part separates the first heating device from the second heating device, to prevent heat dissipated by the first heating device from being directly transferred to the second heating device, so as to slow down heat transfer from the first heating device to the second heating device, thereby alleviating a phenomenon of baking the second heating device by the first heating device, preventing the second heating device from overheating due to baking by the first heating device, ensuring operating reliability of the second heating device, and further ensuring overall operating reliability of the package structure.

In a specific implementable solution, there may be a cavity inside the heat insulation part, and the cavity may be filled with gas in contact with the first housing. In this way, a coefficient of thermal conductivity of the heat insulation part can be reduced, and an effect of blocking heat transfer by the heat insulation part can be enhanced.

In a specific implementable solution, the first end of the heat insulation part may have a first opening, and the cavity is in communication with the first opening. In this way, the gas in the cavity may dissipate, by using the first opening, heat transferred to the heat insulation part to outside of the first housing, so that a heat insulation effect of the heat insulation part can be improved.

In a specific implementable solution, the first housing is filled with a heat conductive medium, and the heat conductive medium fills internal space of the first housing. In this way, heat dissipation of the first heating device and the second heating device can be accelerated, and an overall heat dissipation capability of the package structure can be improved.

In a specific implementable solution, a projection shape of the heat insulation part on the first surface of the circuit board may be a straight line shape or a curve shape. A structure of the heat insulation part is simple, and the heat insulation part can prevent heat dissipated by the first heating device from being transferred to the adjacent second heating device, so as to implement heat insulation between the second heating device and the first heating device.

In a specific implementable solution, a projection shape of the heat insulation part on the first surface of the circuit board may be a fold line shape. In this way, first heating devices located on two adjacent sides of the second heating device can be separated from the second heating device, to implement heat insulation between the second heating device and the two first heating devices.

In a specific implementable solution, a projection shape of the heat insulation part on the first surface of the circuit board may be a U shape. In this way, first heating devices located on three adjacent sides of the second heating device can be separated from the second heating device, to implement heat insulation between the second heating device and the three first heating devices.

In addition to the foregoing arrangement manner, the projection shape of the heat insulation part on the first surface of the circuit board may alternatively be a quadrilateral shape, a circular shape, or an elliptical shape. In this way, a plurality of first heating devices surrounding the second heating device can be separated from the second heating device, to implement heat insulation between the second heating device and the plurality of first heating devices.

In a specific implementable solution, one first heating device may be separated from one second heating device by using a plurality of heat insulation parts. In this way, heat transfer from the first heating device to the second heating device can be further slowed down, and the phenomenon of baking the second heating device by the first heating device can be further alleviated.

In a specific implementable solution, a heat equalizing part may be disposed on an inner wall of the first housing, the heat equalizing part may be disposed at a position corresponding to the first heating device, and the heat equalizing part may abut against the first heating device. The heat equalizing part may be disposed to accelerate heat dissipation of the first heating device, to improve heat dissipation efficiency.

In a specific implementable solution, there may be a second opening at the position that is on the first housing and that corresponds to the heat equalizing part, a heat conductive part may be disposed in the second opening, and the heat conductive part may abut against the heat equalizing part. In this way, the heat equalizing part may transfer heat dissipated by the first heating device to the heat conductive part, and the heat conductive part may then transfer the heat to outside of the first housing, to further accelerate heat dissipation of the first heating device.

In a specific implementable solution, the package structure may further include a second housing, the second housing may be disposed outside the first housing, and an inner wall of the second housing may abut against an outer wall of the first housing. The second housing may be disposed to accelerate heat dissipation of a device inside the first housing to outside, and may further protect the first housing and the device inside the first housing.

In a specific implementable solution, a heat dissipation protrusion or a heat dissipation fin may be disposed on an outer wall of the second housing, to increase a heat dissipation area of the second housing, and improve heat dissipation efficiency.

In a specific implementable solution, the heat dissipation protrusion or the heat dissipation fin is disposed on a side wall, of the second housing, facing toward the first surface of the circuit board and extends outward. In this way, heat dissipation of the first heating device and the second heating device can be accelerated, so that the heat is quickly dissipated outside the second housing.

According to a second aspect, this application provides a photovoltaic optimizer. The photovoltaic optimizer may include a first housing, a second housing, a circuit board, and a heat insulation part. The first housing may be disposed inside the second housing, and there may be a heat conductive connection between the first housing and the second housing, to transfer heat inside the first housing outward. The circuit board is disposed inside the first housing, a first heating device and a second heating device may be disposed on a first surface of the circuit board at an interval, and heat generated by the first heating device at maximum power may be greater than heat generated by the second heating device at maximum power. A first end of the heat insulation part may be located on a side wall, of the first housing, opposite to the first surface of the circuit board, a second end of the heat insulation part may extend toward the first surface of the circuit board, and the heat insulation part separates the first heating device and the second heating device on two sides of the heat insulation part.

In the technical solution provided in this application, the heat insulation part separates the first heating device from the second heating device, to prevent heat dissipated by the first heating device from being directly transferred to the second heating device, so as to slow down heat transfer from the first heating device to the second heating device, thereby alleviating a phenomenon of baking the second heating device by the first heating device, preventing the second heating device from overheating due to baking by the first heating device, ensuring operating reliability of the second heating device, and further ensuring overall operating reliability of the photovoltaic optimizer. In addition, the second housing may be disposed to accelerate heat dissipation of a device inside the first housing to outside, and may further protect the first housing and the device inside the first housing.

In a specific implementable solution, there may be a cavity inside the heat insulation part, and the cavity may be filled with gas in contact with the first housing. In this way, a coefficient of thermal conductivity of the heat insulation part can be reduced, and an effect of blocking heat transfer by the heat insulation part can be enhanced.

In a specific implementable solution, the first end of the heat insulation part may have a first opening, and the cavity may be in communication with space between the first housing and the second housing by using the first opening. In this way, the gas in the cavity may dissipate, by using the first opening, heat transferred to the heat insulation part to a position between the first housing and the second housing, so that heat can be dissipated outside the second housing, and a heat insulation effect of the heat insulation part can be improved.

In a specific implementable solution, a heat equalizing part may be disposed on an inner wall of the first housing, the heat equalizing part may be disposed at a position corresponding to the first heating device, and the heat equalizing part may abut against the first heating device. The heat equalizing part may be disposed to accelerate heat dissipation of the first heating device, to improve heat dissipation efficiency.

In a specific implementable solution, there may be a second opening at the position that is on the first housing and that corresponds to the heat equalizing part, a heat conductive part may be disposed in the second opening, the heat conductive part may abut against the heat equalizing part, and there may be a heat conductive connection between the heat conductive part and the second housing. In this way, the heat equalizing part may transfer heat dissipated by the first heating device to the heat conductive part, and the heat conductive part may then transfer the heat to the second housing, so that the heat can be dissipated outside the second housing, to further accelerate heat dissipation of the first heating device.

In a specific implementable solution, a heat dissipation protrusion or a heat dissipation fin may be disposed on an outer wall of the second housing, to increase a heat dissipation area of the second housing. The heat dissipation protrusion or the heat dissipation fin may be disposed on a side wall, of the second housing, facing toward the first surface of the circuit board and extends outward. In this way, heat dissipation of the first heating device and the second heating device can be accelerated, so that the heat is quickly dissipated outside the second housing.

### BRIEF DESCRIPTION OF DRAWINGS

FIG. 1 is a schematic diagram of an internal structure of a package structure according to an embodiment of this application;
FIG. 2 is a schematic diagram of a structure of a partial structure of a package structure from a perspective according to an embodiment of this application;
FIG. 3 is a schematic diagram of a structure of a partial structure of a package structure from another perspective according to an embodiment of this application;
FIG. 4 is a schematic diagram of a structure of a heat insulation part of a package structure according to an embodiment of this application;
FIG. 5 is a schematic diagram of a structure of a heat insulation part of a package structure according to another embodiment of this application;
FIG. 6 is a schematic diagram of an internal structure of a package structure according to another embodiment of this application;
FIG. 7 is a schematic diagram of a structure of a heat insulation part of a package structure from a perspective according to an embodiment of this application;
FIG. 8 is a schematic diagram of a structure of a heat insulation part of a package structure from another perspective according to an embodiment of this application;
FIG. 9 is a schematic diagram of a structure of a heat insulation part of a package structure from a perspective according to another embodiment of this application;
FIG. 10 is a schematic diagram of a structure of a heat insulation part of a package structure from another perspective according to another embodiment of this application;
FIG. 11 is a schematic diagram of a structure of a heat insulation part of a package structure from a perspective according to another embodiment of this application;
FIG. 12 is a schematic diagram of a structure of a heat insulation part of a package structure from another perspective according to another embodiment of this application;
FIG. 13 is a schematic diagram of a structure of a heat insulation part of a package structure from a perspective according to another embodiment of this application; and
FIG. 14 is a schematic diagram of a structure of a heat insulation part of a package structure from another perspective according to another embodiment of this application.

Reference numerals:
100-first housing; 200-circuit board; 300-heat insulation part; 400-second housing; 101-heat conductive medium; 102-heat equalizing part;
103-heat conductive part; 201-first heating device; 202-second heating device; 401-heat dissipation protrusion; 402-mounting ear structure.

### DESCRIPTION OF EMBODIMENTS

The following describes in detail embodiments of this application with reference to the accompanying drawings.

For ease of understanding, an application scenario of a package structure in this application is first described. A package structure provided in embodiments of this application may be adapted to an electrical control system, for example, may be adapted to a photovoltaic power generation system, and may be specifically used in a photovoltaic optimizer, to improve an electrical energy yield of the system. Certainly, the package structure provided in embodiments of this application may also be used in a power module and another potting or plastic packaging product.

Currently, a heat dissipation capability of the package structure is improved mainly in a manner of filling a heat conductive material as a whole inside a housing. Because the heat conductive material is filled as a whole inside the housing of the package structure, heat of a heating device with a high heat amount and a high temperature specification is transferred to a nearby low-temperature device with a low heat amount and a low temperature specification by using the heat conductive material. As a result, the low-temperature device is baked, causing overheating to the low-temperature device, and affecting overall reliability of the package structure.

Based on this, an embodiment of this application provides a package structure, to alleviate a phenomenon of baking a low-temperature device by a heating device.

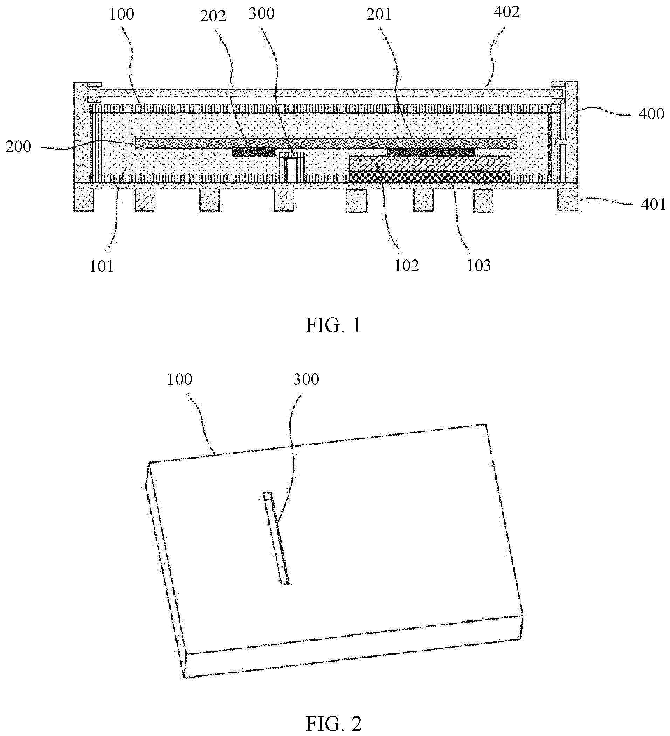

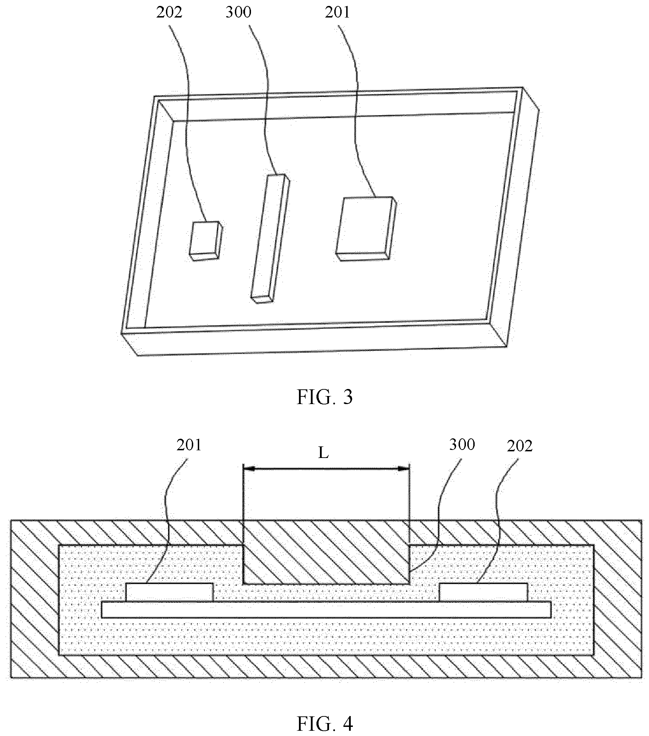

First, with reference to FIG. 1, FIG. 2, and FIG. 3, FIG. 1 is a schematic diagram of an internal structure of a package structure according to an embodiment of this application, FIG. 2 is a schematic diagram of a structure of a partial structure of a package structure from a perspective according to an embodiment of this application, and FIG. 3 is a schematic diagram of a structure of a partial structure of a package structure from another perspective according to an embodiment of this application. As shown in FIG. 1, the package structure provided in this embodiment of this application may include a first housing 100, a circuit board 200, and a heat insulation part 300.

The first housing 100 may be of a hollow structure, and has internal accommodating space. The first housing 100 may be in a cuboid shape, a cylindrical shape, or the like. A shape of the first housing 100 is not limited in this embodiment of this application. The first housing 100 may be made of a plastic material or a metal material. A material of the first housing 100 is not limited in this embodiment of this application, either.

The circuit board 200 may be disposed inside the first housing 100, and a heating device may be disposed on the circuit board 200. In a specific implementation, a heat conductive medium 101 may be filled as a whole inside the first housing 100, and the heat conductive medium 101 may be a potting material or the like. In this way, the internal space of the first housing 100 may be filled with the heat conductive medium 101, so that the heat conductive medium 101 can contact the heating device on the circuit board 200, to accelerate heat dissipation of the heating device on the circuit board 200.

In a specific implementation, the heating device on the circuit board 200 may include a first heating device 201 and a second heating device 202 that are disposed on a first surface of the circuit board 200 at an interval, and heat generated by the first heating device 201 at maximum power is greater than heat generated by the second heating device 202 at maximum power. For example, the first heating device 201 may be an MOSFET, and a temperature specification of the first heating device 201 is usually 150°C; and the second heating device 202 may be a control chip, and a temperature specification of the second heating device 202 is usually 105°C.

With reference to FIG. 1, FIG. 2, and FIG. 3, a first end of the heat insulation part 300 may be fixedly connected to a side wall, of the first housing 100, opposite to the first surface of the circuit board 200. For example, when the first housing 100 is in a cuboid shape, the first housing 100 includes a top wall, a bottom wall, and four side walls. The first surface of the circuit board 200 may be disposed facing toward the bottom wall of the first housing 100, and the first end of the heat insulation part 300 may be fixedly connected to the bottom wall of the first housing 100. A second end of the heat insulation part 300 may extend inside the first housing 100. Specifically, the second end of the heat insulation part 300 may extend toward the first surface of the circuit board 200, and the heat insulation part 300 may separate the adjacent first heating device 201 and second heating device 202 on two sides of the heat insulation part 300, to prevent heat dissipated by the first heating device 201 from being directly transferred to the second heating device 202.

A quantity and arrangement of first heating devices 201 and second heating devices 202 may be specifically determined based on implementations of hardware performance of the package structure, a hardware electrical connection requirement of the package structure, and the like. This is not limited in this embodiment of this application. For example, when the first heating device 201 is disposed on one side of one second heating device 202, the heat insulation part 300 may be disposed between the second heating device 202 and the first heating device 201, and one or more heat insulation parts 300 may be disposed between the second heating device 202 and the first heating device 201, so that the one or more heat insulation parts 300 separate the second heating device 202 from the first heating device 201. When first heating devices 201 are separately disposed on a plurality of sides of one second heating device 202, the heat insulation part 300 may be separately disposed between the second heating device 202 and the adjacent first heating devices 201, and one or more heat insulation parts 300 may be disposed between the second heating device 202 and any one of the adjacent first heating devices 201, so that the one or more heat insulation parts 300 separate the second heating device 202 from any one of the adjacent first heating devices 201.

In a specific implementation, a coefficient of thermal conductivity of the heat insulation part 300 may be less than a coefficient of thermal conductivity of the heat conductive medium 101 filled inside the housing. For example, when the heat conductive medium 101 is a potting material, the heat conductive medium 101 is greater than 1 W/m K. In this case, the heat insulation part 300 may be made of a plastic material, and the heat conductive medium 101 is 0.2 W/m·K. When both the heat insulation part 300 and the first housing 100 are made of plastic materials, the heat insulation part 300 and the first housing 100 may be integrally formed. Specifically, the heat insulation part 300 and the first housing 100 may be integrally formed by using an injection molding process.

In the package structure provided in this embodiment of this application, the heat insulation part 300 separates the first heating device 201 from the second heating device 202, to prevent heat dissipated by the first heating device 201 from being directly transferred to the second heating device 202, so as to slow down heat transfer from the first heating device 201 to the second heating device 202, thereby alleviating a phenomenon of baking the second heating device 202 by the first heating device 201, preventing the second heating device 202 from overheating due to baking by the first heating device 201, ensuring operating reliability of the second heating device 202, and further ensuring overall operating reliability of the package structure.

In a possible embodiment, there may be a cavity inside the heat insulation part 300, and the cavity may be filled with gas in contact with the first housing, or the cavity may be a vacuum environment. For example, the cavity is filled with air, and the heat insulation part 300 is disposed, so that there is an air gap between the adjacent first heating device 201 and second heating device 202. A coefficient of thermal conductivity of air is low, and is only 0.023 W/m·K. Air is a good heat insulation material, and can effectively prevent heat dissipated by the first heating device 201 from being transferred to the second heating device 202. When the cavity is the vacuum environment, an effect of blocking heat transfer by the heat insulation part 300 is more prominent.

In a specific implementation, the first end of the heat insulation part 300 may have a first opening, and the cavity inside the heat insulation part 300 may be in communication with the first opening, so that air in the cavity of the heat insulation part 300 may dissipate, by using the first opening, heat transferred to the heat insulation part 300 to outside of the first housing 100, thereby improving a heat insulation effect of the heat insulation part 300. In addition, the heat insulation part 300 having the first opening may further increase a heat dissipation area of the first housing 100, so that heat dissipation efficiency of the package structure can be improved.

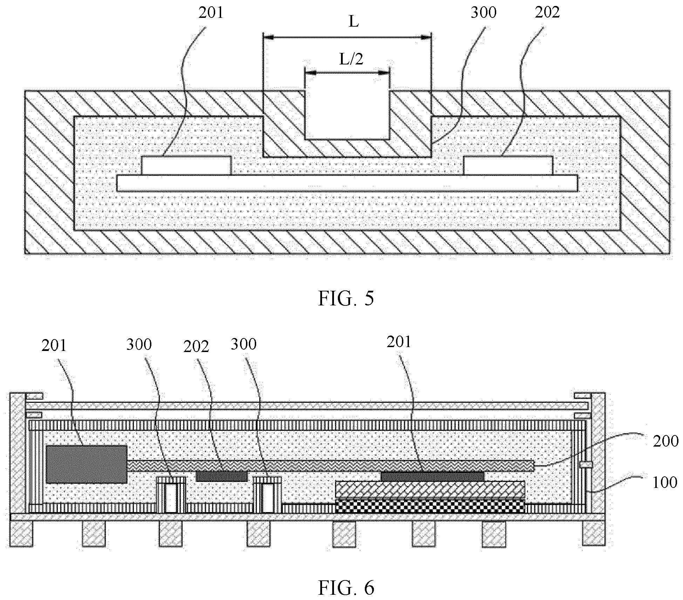

FIG. 4 is a schematic diagram of a structure of a heat insulation part of a package structure according to an embodiment of this application; and FIG. 5 is a schematic diagram of a structure of a heat insulation part of a package structure according to another embodiment of this application. As shown in FIG. 4, the heat insulation part 300 is of a solid structure. For example, in a direction shown in the figure, a width of the heat insulation part 300 is L, for example, L=6 mm, and the heat insulation part 300 is made of a plastic material. In this case, thermal resistance of the heat insulation part 300 is 0.03°C·m²/W. As shown in FIG. 5, there is a cavity inside the heat insulation part 300. For example, in a same direction as that in FIG. 4, a width of the heat insulation part 300 is L, a width of the cavity is L/2, and the heat insulation part 300 is made of a plastic material. In this case, thermal resistance of the heat insulation part 300 is 0.165°C·m²/W. It can be learned from the foregoing that, when the heat insulation part 300 is of a solid structure, the heat insulation part 300 has a prominent heat insulation effect, and can effectively prevent heat dissipated by the first heating device 201 from being transferred to the second heating device 202. When the heat insulation part 300 has a cavity inside, the heat insulation effect is more prominent.

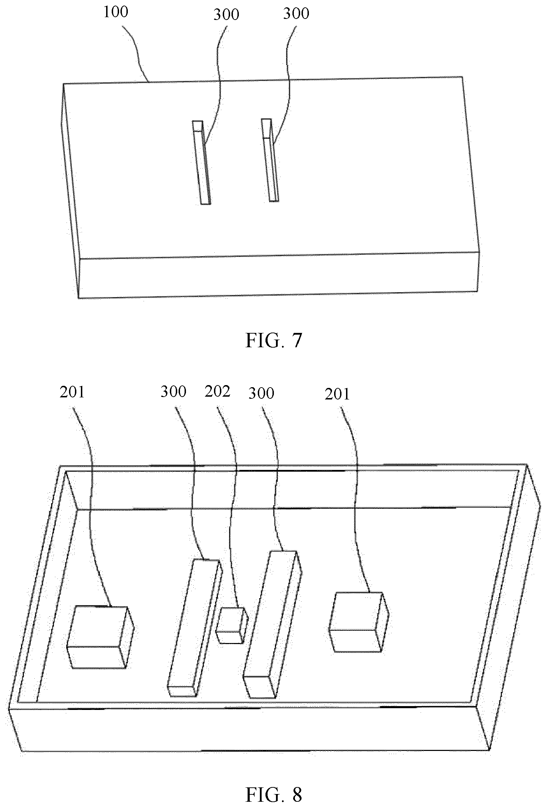

FIG. 6 is a schematic diagram of an internal structure of a package structure according to another embodiment of this application, FIG. 7 is a schematic diagram of a structure of a heat insulation part of a package structure from a perspective according to an embodiment of this application, and FIG. 8 is a schematic diagram of a structure of a heat insulation part of a package structure from another perspective according to an embodiment of this application. In a possible embodiment, the heat insulation part 300 is disposed on the first housing 100, and a projection shape of the heat insulation part 300 on the first surface of the circuit board 200 may be a straight line shape or a curve shape. As shown in FIG. 6, FIG. 7, and FIG. 8, a straight-line-shaped heat insulation part 300 is used as an example. The heat insulation part 300 may be disposed between one second heating device 202 and one adjacent first heating device 201 to separate the second heating device 202 from the first heating device 201, and prevent heat dissipated by the first heating device 201 from being transferred to the second heating device 202. When first heating devices 201 are separately disposed on a plurality of sides of one second heating device 202, the heat insulation part 300 may be disposed between one second heating device 202 and any one of the adjacent first heating devices 201, to ensure that one second heating device 202 is separated from any one of the adjacent first heating devices 201. FIG. 6, FIG. 7, and FIG. 8 illustrate a case in which first heating devices 201 are respectively disposed on two opposite sides of one second heating device 202. In a specific implementation, the heat insulation parts 300 used to separate the second heating device 202 from the adjacent different first heating devices 201 may be not connected to each other, or may be sequentially connected. It may be understood that, when a plurality of heat insulation parts 300 are sequentially connected, the plurality of heat insulation parts 300 may be considered as a heat insulation part 300 with a larger size. The following describes in detail an applicable scenario of this case.

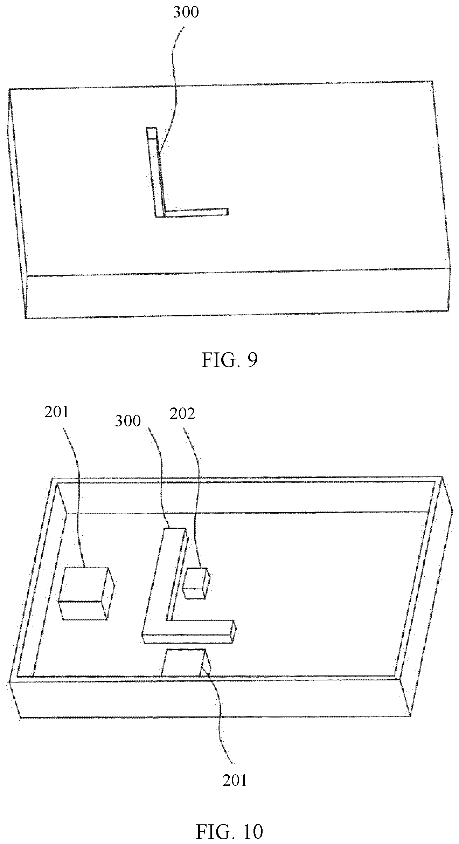

FIG. 9 is a schematic diagram of a structure of a heat insulation part of a package structure from a perspective according to another embodiment of this application; and FIG. 10 is a schematic diagram of a structure of a heat insulation part of a package structure from another perspective according to another embodiment of this application. As shown in FIG. 9 and FIG. 10, in a possible embodiment, a projection shape of the heat insulation part 300 on the first surface of the circuit board may be a fold line shape. The fold-line-shaped heat insulation part 300 may be applicable to a scenario in which first heating devices 201 are respectively disposed on two adjacent sides of one second heating device 202. The fold-line-shaped heat insulation part 300 includes two sides, and the two sides may separately separate the first heating devices 201 located on two adjacent sides of the second heating device 202 from the second heating device 202, to implement heat insulation between the second heating device 202 and the two first heating devices 201. For example, two sides of the fold-line-shaped heat insulation part 300 may be disposed at a right angle, or may be disposed at another angle.

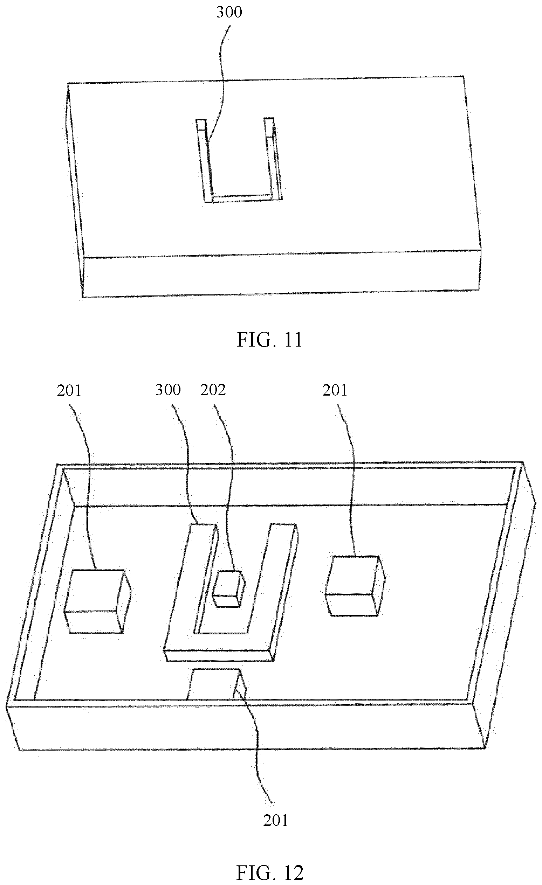

FIG. 11 is a schematic diagram of a structure of a heat insulation part of a package structure from a perspective according to another embodiment of this application; and FIG. 12 is a schematic diagram of a structure of a heat insulation part of a package structure from another perspective according to another embodiment of this application. As shown in FIG. 11 and FIG. 12, in another possible embodiment, a projection shape of the heat insulation part 300 on the first surface of the circuit board may be a U shape. The U-shaped heat insulation part 300 may be applicable to a scenario in which first heating devices 201 are respectively disposed on three adjacent sides of one second heating device 202. The U-shaped heat insulation part 300 may include three sides, and the three sides may separately separate the first heating devices 201 located on the three adjacent sides of the second heating device 202 from the second heating device 202, to implement heat insulation between the second heating device 202 and the three first heating devices 201. The U-shaped heat insulation part 300 may be further applicable to a scenario in which first heating devices 201 are respectively disposed on two opposite or adjacent sides of one second heating device 202. Two opposite sides of the U-shaped heat insulation part 300 may separately separate the first heating devices 201 located on the two opposite or adjacent sides of the second heating device 202 from the second heating device 202, to implement heat insulation between the second heating device 202 and the two first heating devices 201.

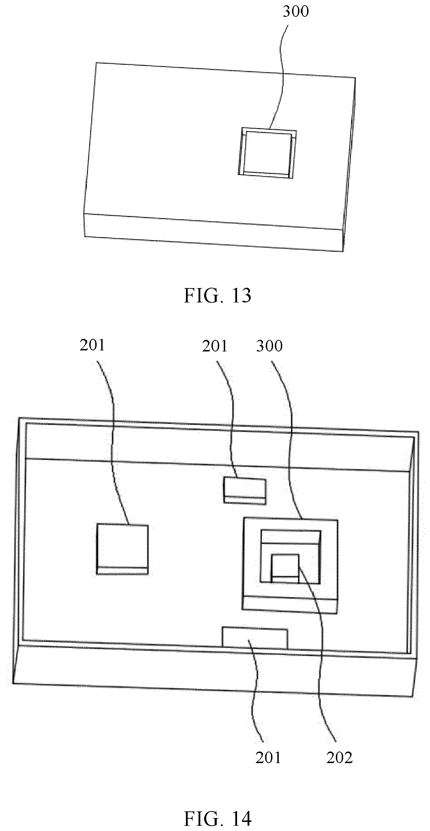

FIG. 13 is a schematic diagram of a structure of a heat insulation part of a package structure from a perspective according to another embodiment of this application, and FIG. 14 is a schematic diagram of a structure of a heat insulation part of a package structure from another perspective according to another embodiment of this application. As shown in FIG. 13 and FIG. 14, in another possible embodiment, a projection shape of the heat insulation part 300 on the first surface of the circuit board may be a quadrilateral shape, a circular shape, or an elliptical shape. In other words, the heat insulation part 300 is of a closed-loop structure. Therefore, in addition to the foregoing three shapes, the heat insulation part 300 may also be of another closed-loop shape. The heat insulation part 300 of the closed-loop structure may be applicable to a scenario in which one second heating device 202 is surrounded by a plurality of first heating devices 201, or applicable to a scenario in which a plurality of first heating devices 201 are irregularly distributed around the second heating device 202. Using a quadrilateral heat insulation part 300 as an example, four sides of the heat insulation part 300 may separate the plurality of first heating devices 201 surrounding the second heating device 202 from the second heating device 202, to implement heat insulation between the second heating device 202 and the plurality of first heating devices 201.

It may be understood that, the fold-line-shaped, U-shaped, quadrilateral, circular, or elliptical heat insulation part 300 may be applicable to a scenario in which a plurality of first heating devices 201 are distributed around one second heating device 202, and may also be applicable to a scenario in which only one first heating device 201 is distributed around one second heating device 202.

With reference to FIG. 1 again, in a possible embodiment, a heat equalizing part 102 may be disposed on an inner wall of the first housing 100. The heat equalizing part 102 may be made of a metal material. A first surface of the first heating device 201 may be disposed facing the circuit board 200, the heat equalizing part 102 may be disposed at a position corresponding to the first heating device 201, and the heat equalizing part 102 may abut against a second surface of the first heating device 201. The second surface of the first heating device 201 is a reverse surface of the first surface. Heat dissipated by the first heating device 201 may be directly transferred to the heat equalizing part 102, and the heat equalizing part 102 may be disposed to accelerate heat dissipation of the first heating device 201, to improve heat dissipation efficiency. In a specific implementation, the heat equalizing part 102 may be of a plate structure, and an area of the heat equalizing part 102 may be greater than an area of the second surface of the first heating device 201, so that the heat equalizing part 102 may completely cover the first heating device 201, making heat dissipation of the first heating device 201 more uniform.

In a specific implementation, there may be a second opening at the position that is on the first housing 100 and that corresponds to the heat equalizing part 102, and a heat conductive part 103 may be disposed in the second opening. In this case, the heat equalizing part 102 abuts against the heat conductive part 103. The heat conductive part 103 may be made of a thermal interface material, and may be filled in the second opening and disposed on the heat equalizing part 102 in a coating manner. The heat equalizing part 102 transfers heat dissipated by the first heating device 201 to the heat conductive part 103, and then the heat conductive part 103 transfers the heat to outside of the first housing 100, so that heat dissipation of the first heating device 201 can be further accelerated.

In a possible embodiment, the package structure may further include a second housing 400. The second housing 400 may be made of a metal material, or may be made of another material with ideal heat dissipation performance. The second housing 400 may be disposed outside the first housing 100, and an inner wall of the second housing 400 may abut against an outer wall of the first housing 100. Therefore, heat dissipation of a device inside the first housing 100 can be accelerated, and the first housing 100 can further resist external force. A shape of the second housing 400 may adapt to a shape of the first housing 100. For example, the second housing 400 may be in a hollow cuboid shape, and the second housing 400 may have a third opening. Specifically, the second housing 400 may include one bottom wall and four side walls. During specific arrangement, the bottom wall of the first housing 100 may abut against the bottom wall of the second housing 400, and the heat conductive part 103 may abut against the bottom wall of the second housing 400.

In a specific implementation, the second housing 400 may alternatively be of a U-shaped structure. Specifically, the second housing 400 may include one bottom wall and two side walls that are disposed opposite to each other. In this case, the bottom wall of the first housing 100 may abut against the bottom wall of the second housing 400, and the heat conductive part 103 may abut against the bottom wall of the second housing 400.

In a specific implementation, a plurality of heat dissipation protrusions 401 or heat dissipation fins may be disposed on an outer wall of the second housing 400, to increase a heat dissipation area of the second housing 400, thereby improving heat dissipation efficiency of the second housing 400, and further improving heat dissipation efficiency of the package structure. Specifically, the heat dissipation protrusion 401 or the heat dissipation fin may be made of a metal material, or the like. When the heat dissipation protrusion 401 or the heat dissipation fin and the second housing 400 are both made of a metal material, the heat dissipation protrusion 401 or the heat dissipation fin may be integrally formed with the second housing 400.

The heat dissipation protrusion 401 or the heat dissipation fin may be disposed on a side wall, of the second housing 400, facing toward the first surface of the circuit board 200 and extends outward. Specifically, the first surface of the circuit board 200 may be disposed facing the bottom wall of the first housing 100, the bottom wall of the first housing 100 may abut against the bottom wall of the second housing 400, and the heat dissipation protrusion 401 or the heat dissipation fin may be disposed on the bottom wall of the second housing 400, so that the heat dissipation protrusion 401 or the heat dissipation fin may be disposed facing the first surface of the circuit board 200, thereby accelerating heat dissipation of the first heating device 201 and the second heating device 202. In addition to being disposed on the bottom wall of the second housing 400, the heat dissipation protrusion 401 or the heat dissipation fin may also be disposed on the side wall of the second housing 400.

In an actual application, a mounting ear structure 402 may be disposed on the second housing 400, so that the second housing 400 is mounted and connected to another structure. Specifically, the mounting ear structure 402 may be made of a metal material. The mounting ear structure 402 may be of a plate structure, and the mounting ear structure 402 may be disposed at the third opening of the second housing 400. Specifically, a groove structure may be provided at the third opening of the second housing 400, and the mounting ear structure 402 may be inserted into the groove structure, so that the mounting ear structure 402 is connected to the second housing 400.

An embodiment of this application further provides a photovoltaic optimizer. With reference to FIG. 1, the photovoltaic optimizer provided in this embodiment of this application may include a first housing 100, a second housing 400, a circuit board 200, and a heat insulation part 300. The first housing 100 may be of a hollow structure, and has internal accommodating space. The first housing 100 may be in a cuboid shape, a cylindrical shape, or the like. The shape of the first housing 100 is not limited in this embodiment of this application. The first housing 100 may be made of a plastic material or a metal material. The material of the first housing 100 is not limited in this embodiment of this application, either. The second housing 400 may be made of a metal material, or may be made of another material with ideal heat dissipation performance. The second housing 400 may be disposed outside the first housing 100, and there may be a heat conductive connection between the second housing 400 and the first housing 100. For example, a gap between the second housing 400 and the first housing 100 may be filled with a heat conductive material, or an inner wall of the second housing 400 may abut against an outer wall of the first housing 100. In this way, heat can be transferred from the first housing 100 to the second housing 400, so that outward heat dissipation of a device inside the first housing 100 is accelerated, and the first housing 100 can further resist external force. A shape of the second housing 400 may adapt to a shape of the first housing 100. For example, when the first housing 100 is in a cuboid shape, the second housing 400 is also in a cuboid shape. The second housing 400 may alternatively be in a U-shaped structure.

The circuit board 200 may be disposed inside the first housing 100, and a heating device may be disposed on the circuit board 200. In a specific implementation, a heat conductive medium 101 may be filled as a whole inside the first housing 100, and the heat conductive medium 101 may be a potting material or the like. In this way, the internal space of the first housing 100 may be filled with the heat conductive medium 101, so that the heat conductive medium 101 can contact the heating device on the circuit board 200, to accelerate heat dissipation of the heating device on the circuit board 200. In a specific implementation, the heating device on the circuit board 200 may include a first heating device 201 and a second heating device 202 that are disposed on a first surface of the circuit board 200 at an interval, and heat generated by the first heating device 201 at maximum power is greater than heat generated by the second heating device 202 at maximum power.

A first end of the heat insulation part 300 may be fixedly connected to a side wall, of the first housing 100, opposite to the first surface of the circuit board 200. For example, when the first housing 100 is in a cuboid shape, the first housing 100 includes a top wall, a bottom wall, and four side walls. The first surface of the circuit board 200 may be disposed facing toward the bottom wall of the first housing 100, and the first end of the heat insulation part 300 may be fixedly connected to the bottom wall of the first housing 100. A second end of the heat insulation part 300 may extend inside the first housing 100. Specifically, the second end of the heat insulation part 300 may extend toward the first surface of the circuit board 200, and the heat insulation part 300 may separate the adjacent first heating device 201 and second heating device 202 on two sides of the heat insulation part 300, to prevent heat dissipated by the first heating device 201 from being directly transferred to the second heating device 202. For a quantity, an arrangement, a shape, and the like of heat insulation parts 300, refer to the foregoing embodiment.

In the photovoltaic optimizer provided in this embodiment of this application, the heat insulation part 300 separates the first heating device 201 from the second heating device 202, to prevent heat dissipated by the first heating device 201 from being directly transferred to the second heating device 202, so as to slow down heat transfer from the first heating device 201 to the second heating device 202, thereby alleviating a phenomenon of baking the second heating device 202 by the first heating device 201, preventing the second heating device 202 from overheating due to baking by the first heating device 201, ensuring operating reliability of the second heating device 202, and further ensuring overall operating reliability of the photovoltaic optimizer. In addition, the second housing 400 may be disposed to accelerate heat dissipation of a device inside the first housing 100 to outside, and may further protect the first housing 100 and the device inside the first housing 100.

In some possible embodiments, there may be a cavity inside the heat insulation part 300, and the cavity may be filled with gas in contact with the first housing. For example, the cavity is filled with air, and the heat insulation part 300 is disposed, so that there is an air gap between the adjacent first heating device 201 and second heating device 202. A coefficient of thermal conductivity of air is low. Air is a good heat insulation material, and can effectively prevent heat dissipated by the first heating device 201 from being transferred to the second heating device 202. In some other possible embodiments, the cavity may be a vacuum environment. When the cavity is the vacuum environment, an effect of blocking heat transfer by the heat insulation part 300 is more prominent.

In a possible embodiment, the first end of the heat insulation part 300 may have a first opening, and the cavity inside the heat insulation part 300 may be in communication with space between the first housing 100 and the second housing 400 by using the first opening. In this way, the gas in the cavity may dissipate, by using the first opening, heat transferred to the heat insulation part 300 to a position between the first housing 100 and the second housing 400, so that heat can be dissipated outside the second housing 400, and a heat insulation effect of the heat insulation part 300 can be improved.

In a possible embodiment, a heat equalizing part 102 may be disposed on an inner wall of the first housing 100, and the heat equalizing part 102 may be made of a metal material. The heat equalizing part 102 may be disposed at a position corresponding to the first heating device 201, and the heat equalizing part 102 may abut against the first heating device 201. Heat dissipated by the first heating device 201 may be directly transferred to the heat equalizing part 102, to accelerate heat dissipation of the first heating device 201 and improve heat dissipation efficiency. In a specific implementation, the heat equalizing part 102 may be of a plate structure, and an area of the heat equalizing part 102 may be greater than an area of the second surface of the first heating device 201, so that the heat equalizing part 102 may completely cover the first heating device 201, making heat dissipation of the first heating device 201 more uniform.

In a possible embodiment, there may be a second opening at the position that is on the first housing 100 and that corresponds to the heat equalizing part 102, and a heat conductive part 103 may be disposed in the second opening. The heat equalizing part 102 abuts against the heat conductive part 103. Specifically, the heat conductive part 103 may be made of a thermal interface material, and may be filled in the second opening and disposed on the heat equalizing part 102 in a coating manner. There may be a heat conductive connection between the heat conductive part 103 and the second housing 400. For example, a gap between the heat conductive part 103 and the second housing 400 may be filled with a heat conductive material, or the heat conductive part 103 may abut against the second housing 400. The heat equalizing part 102 transfers heat dissipated by the first heating device 201 to the heat conductive part 103, and then the heat conductive part 103 transfers the heat to the second housing 400, so that the heat may be dissipated outside the second housing 400, thereby further accelerating heat dissipation of the first heating device 201.

In a possible embodiment, a plurality of heat dissipation protrusions 401 or heat dissipation fins may be disposed on an outer wall of the second housing 400, to increase a heat dissipation area of the second housing 400, thereby improving heat dissipation efficiency of the second housing 400, and further improving overall heat dissipation efficiency of the photovoltaic optimizer. Specifically, the heat dissipation protrusion 401 or the heat dissipation fin may be made of a metal material, or the like. When the heat dissipation protrusion 401 or the heat dissipation fin and the second housing 400 are both made of a metal material, the heat dissipation protrusion 401 or the heat dissipation fin may be integrally formed with the second housing 400. The heat dissipation protrusion 401 or the heat dissipation fin may be disposed on a side wall, of the second housing 400, facing toward the first surface of the circuit board 200 and extends outward, so that heat dissipation of the first heating device 201 and the second heating device 202 can be accelerated.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. A package structure, comprising a first housing, a circuit board, and a heat insulation part, wherein
the circuit board is disposed inside the first housing, a first heating device and a second heating device are disposed on a first surface of the circuit board at an interval, and heat generated by the first heating device at maximum power is greater than heat generated by the second heating device at maximum power; and
a first end of the heat insulation part is located on a side wall, of the first housing, opposite to the first surface of the circuit board, a second end of the heat insulation part extends toward the first surface of the circuit board, and the heat insulation part separates the first heating device and the second heating device that are adjacent to each other on two sides of the heat insulation part.

2. The package structure according to claim 1, wherein there is a cavity inside the heat insulation part, and the cavity is filled with gas in contact with the first housing.

3. The package structure according to claim 2, wherein the first end of the heat insulation part has a first opening, and the cavity is in communication with the first opening.

4. The package structure according to any one of claims 1 to 3, wherein the first housing is filled with a heat conductive medium, and the heat conductive medium fills internal space of the first housing.

5. The package structure according to any one of claims 1 to 3, wherein a projection shape of the heat insulation part on the first surface of the circuit board is a straight line shape, a curve shape, or a fold line shape.

6. The package structure according to any one of claims 1 to 3, wherein a projection shape of the heat insulation part on the first surface of the circuit board is a U shape, a quadrilateral shape, a circular shape, or an elliptical shape.

7. The package structure according to any one of claims 1 to 6, wherein one first heating device is separated from one second heating device by using a plurality of heat insulation parts.

8. The package structure according to any one of claims 1 to 7, wherein a heat equalizing part is disposed on an inner wall of the first housing, the heat equalizing part is disposed at a position corresponding to the first heating device, and the heat equalizing part abuts against the first heating device.

9. The package structure according to claim 8, wherein a second opening is provided at the position that is on the first housing and that corresponds to the heat equalizing part, a heat conductive part is disposed in the second opening, and the heat conductive part abuts against the heat equalizing part.

10. The package structure according to any one of claims 1 to 9, further comprising a second housing, wherein the second housing is disposed outside the first housing, and an inner wall of the second housing abuts against an outer wall of the first housing.

11. The package structure according to claim 10, wherein a heat dissipation protrusion or a heat dissipation fin is disposed on an outer wall of the second housing, to increase a heat dissipation area of the second housing.

12. The package structure according to claim 11, wherein the heat dissipation protrusion or the heat dissipation fin is disposed on a side wall, of the second housing, facing toward the first surface of the circuit board, and extends outward.

13. A photovoltaic optimizer, comprising a first housing, a second housing, a circuit board, and a heat insulation part, wherein
the first housing is disposed inside the second housing, and there is a heat conductive connection between the first housing and the second housing, to transfer heat inside the first housing outward;
the circuit board is disposed inside the first housing, a first heating device and a second heating device are disposed on a first surface of the circuit board at an interval, and heat generated by the first heating device at maximum power is greater than heat generated by the second heating device at maximum power; and
a first end of the heat insulation part is located on a side wall, of the first housing, opposite to the first surface of the circuit board, a second end of the heat insulation part extends toward the first surface of the circuit board, and the heat insulation part separates the first heating device and the second heating device that are adjacent to each other on two sides of the heat insulation part.

14. The photovoltaic optimizer according to claim 13, wherein there is a cavity inside the heat insulation part, and the cavity is filled with gas in contact with the first housing.

15. The photovoltaic optimizer according to claim 14, wherein the first end of the heat insulation part has a first opening, and the cavity is in communication with space between the first housing and the second housing by using the first opening, wherein a heat equalizing part is disposed on an inner wall of the first housing, the heat equalizing part is disposed at a position corresponding to the first heating device, and the heat equalizing part abuts against the first heating device, wherein a second opening is provided at the position that is on the first housing and that corresponds to the heat equalizing part, a heat conductive part is disposed in the second opening, the heat conductive part abuts against the heat equalizing part, and there is a heat conductive connection between the heat conductive part and the second housing., wherein a heat dissipation protrusion or a heat dissipation fin is disposed on an outer wall of the second housing, to increase a heat dissipation area of the second housing; and
the heat dissipation protrusion or the heat dissipation fin is disposed on a side wall of, the second housing, facing toward the first surface of the circuit board, and extends outward.
